# EUROPÄISCHE PATENTSCHRIFT

(11) **EP 1 186 900 B1**
(45) Veröffentlichungstag und Bekanntmachung des Hinweises auf die Patenterteilung: **09.11.2005**
(21) Anmeldenummer: 01000370.5
(22) Anmeldetag: 15.08.2001
(51) Int. Cl.: G01R 31/3181, G01R 31/3187

(54) **Anordnung zum Testen von integrierten Schaltkreisen**
Arrangement for testing integrated circuits
Arrangement pour tester des circuits intégrés

(30) Priorität: 21.08.2000 DE 10041137
(43) Veröffentlichungstag der Anmeldung: 13.03.2002
(73) Patentinhaber: Philips Intellectual Property & Standards GmbH, 20099 Hamburg (DE); Koninklijke Philips Electronics N.V., 5621 BA Eindhoven (NL)
(72) Erfinder: Farkas, Georg c/o Philips Corporate Intellectual, 52064, Aachen (DE); Gappisch, Steffen c/o Philips Corporate Intellect., 52064, Aachen (DE)
(74) Vertreter: Volmer, Georg

(56) Entgegenhaltungen:
- DE-A- 19 834 976
- US-A- 4 389 723
- US-A- 4 519 078
- US-A- 4 813 043

## Beschreibung

Die Erfindung betrifft eine Anordnung zum Testen von integrierten Schaltkreisen, wobei der zu testende integrierte Schaltkreis eine Logikkomponente, eine Testantwortanalyseeinheit zur Komprimierung von Testantwortvektoren und einen Test-Kontroll-Block zur Steuerung des Testablaufs umfasst. Weiter bezieht sich die. Erfindung auf ein Testsystem, einen zu testenden integrierten Schaltkreis und ein Verfahren zum Testen von Logikschaltkreisen.

Um Logikkomponenten oder Logikschaltkreise zu testen, werden bekannterweise Testsysteme verwendet, bei denen die für einen Test erforderlichen Testvektoren in einem großen Testvektorspeicher gespeichert sind. Testvektoren stellen eine Anzahl von logischen Mustern dar. Neben dieser Testanordnung besteht eine Alternative in der Verwendung von in die zu testenden Schaltkreise oder ICs (Device under Test DUT) zu integrierende Selbsttesteinheiten oder BIST-Einheiten (Built In Self Test). Bei diesen BIST-Einheiten werden die Testvektoren auf dem DUT generiert und auch die Testantwortvektoren auf dem DUT verarbeitet. Die auf dem DUT integrierten BIST-Einheiten verbrauchen jedoch zusätzliche Siliziumfläche.

Die zuerst genannten Testsysteme können entweder mit sehr großen Testspeichern ausgestattet sein, wodurch jedoch die Komplexität und auch der Preis derartiger Testsysteme steigt oder es werden Testsysteme benutzt, die mittels eines einfachen algorithmischen Testvektorgenerator (APG) entsprechende Testvektoren erzeugen. Testsysteme für Speicher ICs erzeugen mittels dieser APGs die Testvektoren. Dabei ist die Erzeugung der Speichertestvektoren auf einfache Testvektoren, die hauptsächlich aus Adressen- und Datenwerten bestehen, beschränkt.

Bei Submikronprozessen können Defekttypen auftreten, die eine signifikant höhere Anzahl von Testvektoren erfordern. Für diese erhöhte Anzahl von Testvektoren ist ein noch wesentlich größerer und teurer Testvektorspeicher erforderlich.

Die andere genannte Alternative, Logikschaltkreise zu testen, wäre eine BIST- Einheit auf derartigen ICs zu integrieren. Der Nachteil dieser Methode besteht darin, dass zusätzliche Siliziumfläche benötigt wird und auch ein entsprechendes Design für den Test der speziellen ICs erforderlich ist. Eine derartige BIST-Einheit würde Testvektoren auf dem Chip generieren. Die Testantwort würde nach Durchlaufen der Testvektoren durch die Logik auf dem Chip von einer Analyseeinheit in eine Signatur komprimiert werden. An einem Ausgang des Schaltkreises ist dann die Signatur abgreifbar.

Aus der DE 198 34 976 A1 ist eine integrierte Schaltung mit eingebautem Baugruppentest bekannt. Mit der Schaltung wird die interne als auch extern angeordnete Logik getestet. Die Schaltung ist dazu vorgesehen, beim Einschalten des integrierten Schaltkreises einen Test durchzuführen. Über Ein- und Ausgangsanschlüsse der integrierten Schaltung werden Testvektoren an die externe Logik der Baugruppe ausgegeben. Die externe Logik erzeugt eine Testantwort und führt diese der Selbsttestschaltung zu.

Die US 4,813,043 beschreibt ein Halbleiter-Testgerät, das einen algorithmischen Testvektorgenerator enthält, der komplizierte Testvektoren erzeugen kann.

Es ist Aufgabe der Erfindung, eine Anordnung und eine Verfahren zum Testen von Logikschaltkreisen bereitzustellen, die wenig zusätzlichen Platz auf dem zu testenden IC (DUT) beanspruchen, ohne die Testperformance herabzusetzen und ohne große Testspeicher zu verwenden.

Die Aufgabe der Erfindung wird durch die Merkmale der unabhängigen Ansprüche gelöst.

In das Testsystem ist ein Testvektorgenerator implementiert, der programmierbar ist und in der Lage ist, Testvektoren zu generieren, die zu dem DUT übertragen werden. In den Testvektorgenerator ist ein Algorithmus implementiert, der programmierbar ist. Im DUT durchlaufen die Testvektoren eine zu testende Logikkomponente und werden zu einer Testantwortanalyseeinheit übertragen. In dieser Testantwortanalyseeinheit durchlaufen die Testantwortvektoren eine sequentielle Logik, werden komprimiert und es wird eine Checksumme gebildet. Die Checksumme wird mittels eines Testkontrollblocks zum Testsystem übertragen, wo ein Vergleich der gebildeten Testchecksumme mit einer Referenzchecksumme vorgenommen wird.

Die Testvektoren werden wie bei dem BIST-System in Echtzeit erzeugt, jedoch auf dem Testsystem. Der große und teure Speicher für die Testvektoren auf dem Testsystem wird durch den programmierbaren algorithmischen Testvektorgenerator ersetzt, der die Testvektoren erzeugt. Dieser Testvektorgenerator enthält einen Prozessor, insbesondere eine arithmetische Logik Einheit (ALU) und ist durch Programmierung in der Lage die entsprechend erforderlichen Testvektoren in Echtzeit zu erzeugen.

Vorteilhaft bei dieser Realisierung ist das Testen mit hoher Geschwindigkeit, da das Testsystem das DUT schnell treiben kann und die Datenmengen, die vom DUT zum Testsystem übertragen werden, gering sind.

Der Testkontrollblock ist für das Umschalten zwischen den unterschiedlichen Modi verantwortlich. Für einen Test muss das DUT vom normalen Betrieb zum Testmode umgeschaltet werden. Der Testkontrollblock kontrolliert das Umschalten von einem Normalbetrieb des Schaltkreises in einen Testmodus. Dabei isoliert der Testkontrollblock die Logikkomponente von einer für einen Test nicht erforderlichen Peripherie und steuert alle notwendigen Kontroll- und Datensignale, die zur Übertragung der Testvektoren vom Testsystem zum DUT und zur Übertragung von Testantworten und/oder Checksummen vom DUT zum Testsystem erforderlich sind.

Wenn die Testantwortanalyseeinheit im DUT implementiert ist, wird letztendlich nur die Checksumme mittels des Testkontrollblocks zum Testsystem übertragen. Dies hat den Nachteil, dass eine Fehlerlokalisierung nicht möglich ist, da nicht nachvollziehbar ist, weshalb die Checksumme in der vorliegenden Fassung zustande gekommen ist. Ist die Testantwortanalyseeinheit jedoch auf dem Testsystem integriert, werden die Testantwortvektoren, nachdem die Testvektoren die Logikkomponente auf dem DUT durchlaufen haben, direkt zum Testsystem übertragen, so dass eine Fehlerlokalisierung möglich ist.

Vorteilhaft bei der Erfindung ist weiterhin, dass durch die Programmierung des Testvektorgenerators mit seinem Prozessor eine Veränderung der Testvektoren leicht möglich ist, was bei bekannten BIST-Testanordnungen nicht möglich ist.

Als deutlichster Vorteil der Erfindung ist hervorzuheben, dass durch den programmierbaren Testvektorgenerator einfache Testsysteme modifiziert werden können, so dass durch die Erzeugung von sowohl Pseudozufallstestvektoren als auch von deterministischen Testvektoren Logikkomponenten getestet werden können.

Bei der Ausführung der Erfindung nach Anspruch 1 ist es notwendig, die Testantwortanalyseeinheit auf dem DUT zu designen.

Nachfolgend wird anhand der Zeichnung ein Ausführungsbeispiel näher beschrieben:
- Fig. 1: ein Testsystem mit Testvektorspeicher nach dem Stand der Technik,
- Fig. 2: BIST-Testanordnung nach dem Stand der Technik,
- Fig 3: DUT mit Testantwortanalyseeinheit und Testsystem mit Testvektorgenerator,
- Fig 4: Testsystem mit Testvektorgenerator und Testantwortanalyseeinheit.

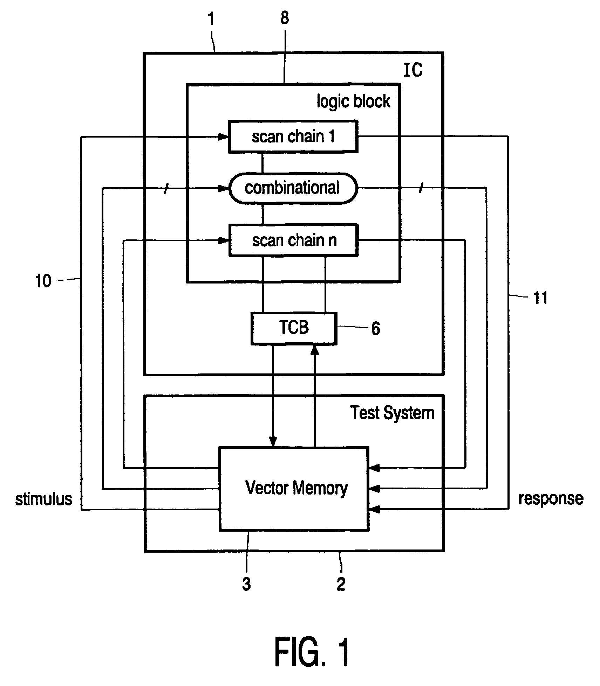

In Fig. 1 ist der DUT 1 und das Testsystem 2 dargestellt. Das Testsystem 2 beinhaltet den Testvektorspeicher 3. Dieser Testvektorspeicher 3 erreicht leicht Größen von mehreren Megabyte. Im DUT ist eine Logikkomponente 8 enthalten. Das Umschalten zwischen Testmode und normalem Betriebsmodus erfolgt mittels Testkontrollblock 6, der auch den Austausch von Steuerungsdaten zwischen Testsystem und dem DUT kontrolliert. Über die Verbindungen 10 werden die Testvektoren und über die Verbindungen 11 die Testantwortvektoren übertragen.

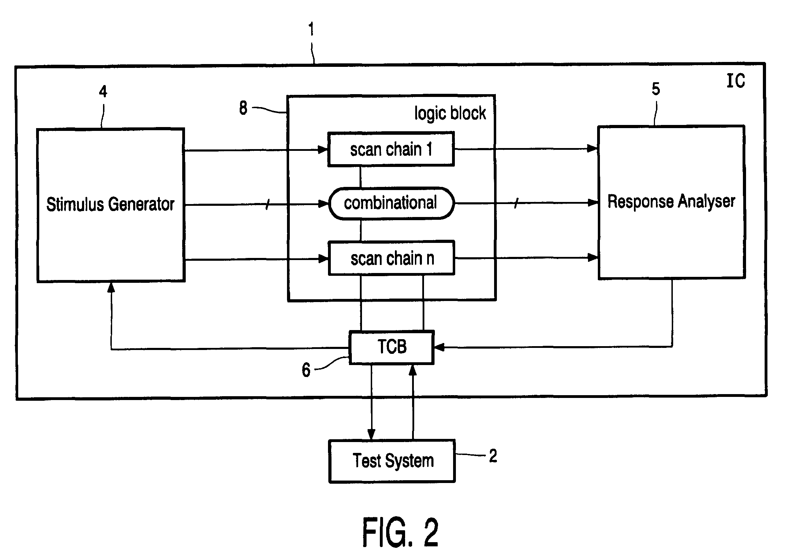

Fig 2 zeigt einen aus dem Stand der Technik bekannte BIST-Einheit mit einem Testsystem. In den DUT 1 ist der programmierbare algorithmische Testvektorgenerator 4, die Logikkomponente 8, der Testkontrollblock 6 und die Testantwortanalyseeinheit 5 implementiert. Das Testsystem 2 initiiert und kontrolliert den Testablauf und bewertet die vom DUT 1 erzeugte und zum Testsystem 2 übertragene Checksumme, indem diese Check summe mit einer Referenzchecksummen auf dem Testsystem verglichen wird.

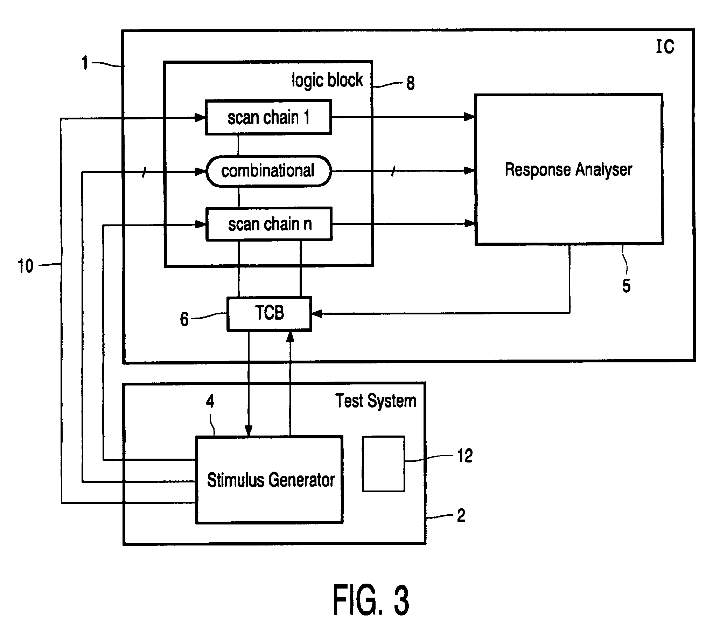

Fig. 3 zeigt eine erfindungsgemäße Realisierung einer derartigen Testanordnung. Der zu testende IC 1 (DUT) enthält eine Logikkomponente 8, einen Testkontrollblock 6 und eine Testantwortanalyseeinheit 5. Das Testsystem 2 enthält den programmierbaren algorithmischen Testvektorgenerator 4 mit einem Prozessor 12. Dieser Testvektorgenerator erzeugt Testvektoren und überträgt diese über die Verbindung 10 zum DUT 1, wo die Testvektoren die Logikkomponente 8 durchlaufen. Die Testantwortvektoren werden zur Testantwortanalyseeinheit 5 übertragen, wo sie eine sequentielle Logik durchlaufen und in eine Checksumme gebildet wird. Diese Checksumme wird unter Kontrolle des Testkontrollblocks 6 an einen primären Ein/Ausgang des Test IC angelegt, von dem das Testsystem 2 sich diese Checksumme abgreifen kann und mit einer Referenzchecksumme vergleichen kann und somit eine Entscheidung über ein positives oder negatives Testergebnis fällen kann.

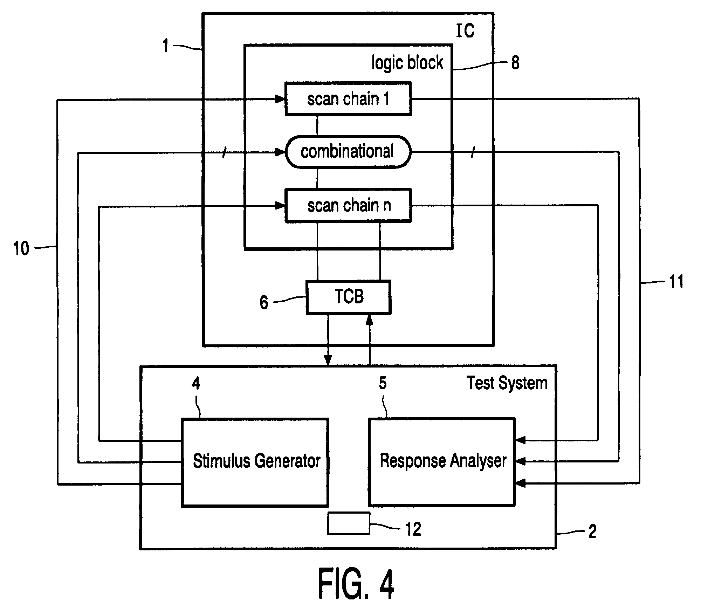

In Fig. 4 zeigt eine weitere Ausführungsform einer erfindungsgemäßen Anordnung zum Testen von Logikschaltkreisen. Der DUT 1 enthält eine Logikkomponente 8 und den Testkontrollblock 6. In das Testsystem 2 ist der programmierbare algorithmische Testvektorgenerator 4, der Prozessor 12 und die Testantwortanalyseeinheit 5 integriert. Über die Verbindung 10 werden die Testvektoren vom programmierbaren algorithmischen Testvektorgenerator zum DUT 1 übertragen. Dort durchlaufen sie die Logikkomponente 8. Die Testantwortvektoren werden über die Verbindung 11 zur Testantwortanalyseeinheit 5 im Testsystem 2 übertragen, wo diese Testantwortvektoren komprimiert werden und eine Checksumme gebildet wird. Diese Checksumme wird mit einer im Testsystem gespeicherten Referenzchecksumme verglichen, um ein Testergebnis zu erzeugen.

Der Prozessor 12 übernimmt sowohl das Erzeugen der Testvektoren in Echtzeit , als auch das Komprimieren der vom DUT 1 übertragenen Testantwortvektoren.

Ein Multiple Input Shifts Register (MISR) ist eine Hardwareimplementierung für eine Testantwortanalyseeinheit. Es komprimiert alle Ausgänge in eine Signatur oder Checksumme. Dies Methode wird auch zyklische Redundanzüberprüfung (cyclic redundancy Check CRC) genannt. Eine weitere Realisierung einer Testantwortanalyseeinheit ist ein Adder, der dann jeveils eine Checksumme bildet. Die Testantwortanalyseeinheit ist auch mittels eines Prozessors realisierbar.

Es gibt mehrere Möglichkeiten, wo das Ergebnis eines derartigen Tests oder die Fehleraussage erzeugt wird. Die zuvor berechnete Referenzchecksumme kann entweder im DUT 1 gespeichert sein und wird dann demzufolge auch in diesem DUT 1 verglichen und gibt als Fehleraussage eine Pass- oder Fail Entscheidung aus. Ebenso ist es möglich, dass diese Referenzchecksumme auf dem Testsystem gespeichert ist und auch der Vergleich dort vorgenommen wird.

## Patentansprüche

1. Integrierter Schaltkreis (1) mit einer zu testenden Logikkomponente (8), einer Testantwortanalyseeinheit (5) und einem Test-Kontroll-Block (6), wobei die Logikkomponente (8) zum Empfang von Testvektoren und zur Ausgabe von Testantwortvektoren vorgesehen ist, die Testantwortanalyseeinheit (5) zur Komprimierung von Testantwortvektoren und der Test-Kontroll-Block (6) zur Steuerung eines Testablaufs vorgesehen ist,
**dadurch gekennzeichnet,**
**dass** ein örtlich getrennt zum zu testenden integrierten Schaltkreis (1) angeordnetes Testsystem (2) mit dem Schaltkreis (1) elektrisch gekoppelt ist, wobei die Testantwortanalyseeinheit (5) zur Erzeugung einer Checksumme aus den Testantwortvektoren und zur Zuführung der Checksumme zum separat angeordneten Testsystem (2) unter Steuerung des Testkontrollblockes (6) vorgesehen ist.

2. Integrierter Schaltkreis (1) nach Anspruch 1,
**dadurch gekennzeichnet,**
**dass** die Testantwortanalyseeinheit (5) eine sequentielle Logik zur Bildung der Checksumme aus den Testantwortvektoren umfasst.

3. Testsystem (2) mit einem programmierbaren algorithmischen Testvektorgenerator (4) zur Erzeugung von Testvektoren, die zur Übertragung zu einem zu testenden Schaltkreis (1) vorgesehen sind,
**dadurch gekennzeichnet,**
**dass** im Testsystem (2) eine Referenzchecksumme gespeichert ist und dem Testsystem (2) eine aus Testantwortvektoren auf einem zu testenden Schaltkreis (1) gebildete Checksumme von dem zu testenden Schaltkreis (1) zuführbar ist, wobei auf dem Testsystem (2) ein Vergleich zwischen Referenzchecksumme und der zugeführten Checksumme zur Bildung eines Testergebnisses vorgesehen ist.

4. Anordnung zum Testen eines integrierten Schaltkreises (1) gemäß Anspruch 1, und einem Testsystem (2) gemäß Anspruch 3, das örtlich getrennt zum zu testenden integrierten Schaltkreis (1) angeordnet und elektrisch mit dem Schaltkreis (1) gekoppelt ist und der Testvektorgenerator (4) eine arithmetische Logik Einheit (ALU) zur Erzeugung von Testvektoren in Echtzeit aufweist, wobei die auf dem zu testenden integrierten Schaltkreis (1) angeordnete Testantwortanalyseeinheit (5) eine Checksumme erzeugt, die zur Zuführung zum separat angeordneten Testsystem (2) vorgesehen ist.

5. Verfahren zum Testen von integrierten Schaltkreisen (1), bei dem der zu testende integrierte Schaltkreis (1) eine Logikkomponente (8), eine Testantwortanalyseeinheit (5) und einen Test-Kontroll-Block (6) umfasst,
**dadurch gekennzeichnet,**
**dass** der zu testende integrierte Schaltkreis (1) mit einem örtlich getrennt angeordneten Testsystem (2) verbunden wird, in dem von einem programmierbaren algorithmischen Testvektorgenerator (4) Testvektoren erzeugt werden, die zum zu testenden Schaltkreis (1) übertragen werden und von der Testantwortanalyseeinheit (5) eine Checksumme erzeugt wird, die dem separat angeordneten Testsystem (2) zugeführt wird.

## Claims

1. An integrated circuit (1) comprising a logic component (8) to be tested, a test response analysis unit (5) and a test control block (6), the logic component (8) being provided for receiving test vectors and for issuing test response vectors, the test response analysis unit (5) being provided for compressing test response vectors and the test control block (6) being provided for controlling a test routine, **characterized in that** a test system (2) spatially separated from the integrated circuit to be tested (1) is electrically coupled to the circuit (1), the test response analysis unit (5) being provided for generating a check sum from the test response vectors and for applying the check sum to the separately arranged test system (2) under the control of the test control block (6).

2. An integrated circuit (1) as claimed in claim 1, **characterized in that** the test response analysis unit (5) comprises a sequential logic unit for forming the check sum from the test response vectors.

3. A test system (2) comprising a programmable algorithmic test vector generator (4) for generating test vectors which are intended to be applied to a circuit (1) to be tested, **characterized in that** a reference check sum is stored in the test system (2) and a check sum formed from test response vectors on a circuit (1) to be tested can be applied to the test system (2) by the circuit (1) to be tested, a comparison being effected on the test system (2) between the reference check sum and the applied check sum to form a test result.

4. An arrangement for testing an integrated circuit (1) as claimed in claim 1, and a test system (2) as claimed in claim 3, which test system (2) is arranged spatially separated from the integrated circuit (1) to be tested and is electrically coupled to the circuit (1) and the test vector generator (4) includes an arithmetic and logic unit (ALU) for generating real-time test vectors, the check response analysis unit (5) arranged on the integrated circuit (1) to be tested generating a check sum which is provided to be applied to the separately arranged test system (2).

5. A method of testing integrated circuits (1) in which the integrated circuit (1) to be tested comprises a logic component (8), a test response analysis unit (5) and a test control block (6), **characterized in that** the integrated circuit (1) to be tested is connected to a spatially separately arranged test system (2) in which test system (2) are generated test vectors in the programmable algorithmic test vector generator (4) which test vectors are applied to the circuit (1) to be tested and the test response analysis unit (5) generating a check sum which is applied to the separately arranged test system (2).

## Revendications

1. Circuit intégré (1) avec un composant logique (8) à tester, une unité d'analyse des réponses de test (5) et un bloc de contrôle de test (6), le composant logique (8) étant prévu pour la réception de vecteurs de test et pour la sortie de vecteurs de réponse de test, l'unité d'analyse des réponses de test (5) pour la compression de vecteurs de réponse de test et le bloc de contrôle de test (6) pour la commande d'un déroulement de test,
**caractérisé en ce**
**qu'**un système de test (2) séparé spatialement du circuit (1) intégré à tester est couplé électriquement avec le circuit (1), l'unité d'analyse des réponses de test (5) étant prévue pour la production d'une somme de contrôle à partir des vecteurs de réponse de test et pour l'apport de la somme de contrôle vers le système de test (2) disposé séparément sous la commande du bloc de contrôle de test (6).

2. Circuit (1) intégré selon la revendication 1,
**caractérisé en ce**
**que** l'unité d'analyse des réponses de test (5) comprend une logique séquentielle pour la formation de la somme de-contrôle à partir des vecteurs de réponse de test.

3. Système de test (2) avec un générateur algorithmique programmable de vecteurs de test (4) pour la production de vecteurs de test qui sont prévus pour la transmission vers un circuit (1) à tester,
**caractérisé en ce**
**qu'**une somme de contrôle de référence est enregistrée dans le système de test (2) et une somme de contrôle formée à partir des vecteurs de réponse de test sur un circuit (1) à tester peut être amenée au système de test (2) par le circuit (1) à tester, une comparaison entre la somme de contrôle de référence et la somme de contrôle amenée étant prévue pour la formation d'un résultat de test sur le système de test (2).

4. Dispositif de test d'un circuit intégré (1) selon la revendication (1) et d'un système de test (2) selon la revendication 3, qui est disposé séparé spatialement du circuit (1) intégré à tester et est couplé électriquement au circuit (1) et le générateur de vecteurs de test (4) présente une unité logique arithmétique (ALU) pour la production de vecteurs de test en temps réel, l'unité d'analyse des réponses de test (5) disposée sur le circuit (1) intégré à tester produisant une somme de contrôle qui est prévue pour être amenée vers un système de test (2) disposé séparément.

5. Procédé de test de circuits intégrés (1) dans lequel le circuit intégré à tester (1) présente un composant logique (8), une unité d'analyse des réponses de test (5) et un bloc de contrôle de test (6),
**caractérisé en ce**
**que** le circuit (1) intégré à tester est relié à un système de test (2) disposé spatialement séparé dans lequel des vecteurs de test sont produits par un générateur algorithmique programmable de vecteurs de test (4), lesquels sont transmis vers le circuit (1) à tester et une somme de contrôle est produite par l'unité d'analyse des réponses de test (5) et est amenée au système de test (2) disposé séparément.
